# EUROPEAN PATENT APPLICATION

(11) **EP 1 052 689 A1**
(43) Date of publication of application: **15.11.2000**
(21) Application number: 00109194.1
(22) Date of filing: 09.05.2000
(51) Int. Cl.: H01L 21/3213, C23F 4/00

(54) **Method for anisotropic etching of copper thin films with a beta-diketone, a beta-ketoimine, or a breakdown product thereof**

(30) Priority: 10.05.1999 US 309250
(71) Applicant: AIR PRODUCTS AND CHEMICALS, INC., Allentown, PA 18195-1501 (US)
(72) Inventor: George, Mark Allen, Santa Rosa, CA 95404 (US); Bohling, David Arthur, Petaluma, CA 94954 (US); Langan, John Giles, Pleasanton, CA 94566 (US); Beck, Scott Edward, Kutztown, PA 19530 (US)
(74) Representative: Schwabe - Sandmair - Marx

(57) **Abstract**

This invention provides a method for anisotropically etching copper thin films for nanofabrication. Surface modifications in a direction perpendicular to the surface of the copper thin film facilitates anisotropic etching with a β-diketone, a β-ketoimine or a breakdown product thereof, such as 1,1,1,5,5,5-hexafluoro-2,5-pentanedione (H⁺hfac). The surface modification described can be anisotropic copper oxidation by exposure to a plasma or a directed ion beam. Ion implantation can be used to introduce the oxygen into the region where copper etching is desired or to damage the etch region enough to promote enhanced oxidation in that region. Masking schemes are also disclosed for use with ion implantation.

## Description

### CROSS-REFERENCE TO RELATED APPLICATIONS

Not applicable.

### STATEMENT REGARDING FEDERALLY SPONSORED RESEARCH OR DEVELOPMENT

Not applicable.

### BACKGROUND OF THE INVENTION

This invention relates to microfabrication methods, and more particularly to methods for anisotropically etching copper thin films for nanofabrication of integrated circuits and the like.

Since the advent of silicon based integrated circuits, the electronics industry has constantly sought to decrease the size of such circuits. The effects of continued miniaturization of silicon based integrated circuits are two-fold. The first effect is physical. As the minimum feature size decreases, physical deposition techniques fail to provide uniform coverage and completely fill features. The second effect is electrical. As the feature size decreases and devices switch at faster rates, delays due to interconnect resistivity and capacitance (commonly called RC delays) hinder device performance.

The shrinkage of silicon based integrated circuits is initiating a change from standard interconnect metallization material. Aluminum has been used as the metal of choice due to its relatively low bulk resistivity (2.7µΩ-cm), its ease of deposition by physical methods, and its amenability to anisotropic etching by RF plasma techniques. However, as the size of integrated circuits continues to decrease, it has become increasingly difficult to provide uniform coverage by physical deposition of aluminum on a substrate.

The limitation of physical deposition to provide uniform coverage catalyzed the development of chemical vapor deposition (CVD) processes. Tungsten has been a preferred metallization material for CVD processes. See, e.g., Sachdev et al., "CVD Tungsten and Tungsten Silicide for VLSI Applications," Semiconductor International, p.306 (May 1985). In tungsten CVD, tungsten is deposited via a surface reaction between a halide precursor, WF₆ or WCl₆, and a reducing agent such as H₂ or SiH₄. The advantage of tungsten is that it is easily etched anisotropically by fluorine or chlorine containing RF plasmas. However, the bulk resistivity of tungsten, 3.5µΩ-cm, is too large for use as a general interconnect material. Therefore, the electronics industry is looking to other materials which have a low resistivity (<2.7µΩ-cm), are able to be deposited by CVD or other techniques which provide for good step coverage, and are able to be anisotropically etched at low temperatures (<150°C) or can easily be chemically mechanically polished.

Copper is one material currently used as an interconnect material. Numerous researchers have reported successful deposition of copper utilizing various organometallic precursors. See, e.g., Cohen et al., Appl. Phys. Lett. 60(13), pp. 1585-1587 (1992), and Farkas et al., *Advanced Metallization for ULSI Applications,* edited by Fana et al. (Materials Research Society, Pittsburgh, PA, 1992) p. 527. Grain size, impurities, and resistivity of the deposited film can be controlled by processes developed for deposition of copper from these precursors.

Farkas et al., J. Appl. Phys., Vol. 73, No. 3, pp. 1455-1460 (1993) demonstrated a copper etching process via a modified copper surface. Utilizing a well known process of chlorinating a copper surface, Farkas et al. showed etching of copper by the following reactions:

CuCl₍ₛ₎ + PET ⇒ CuClPET₍ₛ₎ + PET ⇒ CuCl(PET)_{2(g)} (1)

Cl₂₍ₛ₎ + PET_{(g)} ⇒ Cl₂PET_{(g)} (2)

where PET is triethylphosphine. The first reaction results in the etching of the chlorinated copper film via the removal of a CuCl species, and the second reaction is a competing reaction which competes with the CuCl for the available PET. The chlorinated layer has been shown by Sesselman et al., Surface Science, 176, 67 (1986) to be approximately 1000 Å at 320 K. Unfortunately, the copper etching methods of Farkas et al. are isotropic, that is, horizontal and vertical etch rates are equivalent.

U.S. Patent No. 5,221,366 to Roberts et al. discloses a vapor-phase process for isotropically etching metallic layers during the manufacturing of integrated circuits. The process comprises contacting a portion of the metallic surface to be etched with an effective amount of an etching agent comprising a β-diketone or β-ketoimine dispersed in an atmosphere capable of oxidizing the metal to be removed at a temperature sufficient to form a volatile metal-ligand complex. The volatile metal-ligand complex is sublimed from the surface thereby etching successive layers of the metal. Roberts et al. exemplifies isotropically etching copper from a copper film substrate heated to 240°C for 30 minutes in the presence of hexafluoroacetylacetone as an etching agent.

While Roberts et al. teaches a useful method for isotropically etching metals, the utility of an anisotropic etching method for copper cannot be ignored for next generation integrated circuits. In order to provide an anisotropic etch, some modification of the copper film can be made such that the film is only removed in a direction perpendicular to the surface. Standard lithographic techniques use a polymer or spin-on-glass mask to protect areas where etching is not desired. In the case of RF plasma processes, ion bombardment in the direction perpendicular to the film surface enhances the etch rate in those areas subjected to the flux of ions. However, the copper etching processes described above do not occur in a plasma environment. In fact, the chemical species responsible for etching would dissociate in a plasma, thus rendering them ineffective as etching chemicals.

Halogen based plasma etching techniques, including the use of molecules such as Cl₂, BCl₃, or l₂, have been used to etch copper. Other potential chemistries include the combination of chlorine and carbon monoxide. Each of these techniques results in substantial corrosion and/or oxidation of the copper and of etch masks used to define patterns. Masks used for these processes include photoresists or spin-on-glasses. Each of these affords little protection of underlying copper from corrosion or oxidation by such techniques.

A process based on Cl₂ plasma and incident infrared (IR) radiation on a masked substrate is taught by Hosoi et al., Appl. Phys. Lett., 63 (19), pp. 2703-2704 (1993). The combination of exposure to IR and the plasma results in copper etching. This etching chemistry leaves a CuClₓ residue on the surface and undercuts the copper, although the reference asserts otherwise. The intensity of the IR lamp was centered at 1 micron. Photons of this energy are not sufficiently energetic to desorb or dissociate CuClₓ. Further, the reference bases the assertion on an SEM analysis, which is not an appropriate method for analyzing for CuClₓ.

U.S. Patent No. 5,782,986 to Butterbaugh et al. discloses a method for removing a metallic material from a substrate, comprising irradiating the substrate with ultraviolet light in conjunction with exposing the substrate to a gaseous environment including a metal complexing ligand selected from the group consisting of β-diketones and β-ketoimines, so as to form a metal-ligand compound, which is volatilized and removed from the substrate.

U.S. Patent No. 5,705,443 to Stauf et al. discloses a plasma-assisted dry etching process for etching a metal layer on a substrate. The process comprises plasma etching in combination with contacting the metal layer with an etch enhancing material, such as a β-diketone. Stauf et al. does not disclose or suggest using a plasma to anisotropically oxidize the metal layer, but rather teaches away from the concept in disclosing reducing plasmas for etching.

Despite the foregoing developments, there is still room for improvement in methods for anisotropically etching copper. Ultraviolet irradiation based methods, such as those of Butterbaugh et al. are relatively difficult to control. For example, ultraviolet irradiation can reflect from a target surface and damage a non-target surface of the substrate, leading to imperfections in the etched product.

Accordingly, it is desired to have an improved method for etching copper.

All references cited herein are incorporated herein by reference in their entireties.

### BRIEF SUMMARY OF THE INVENTION

The invention provides a method for etching copper from a substrate, said method comprising: anisotropically oxidizing said copper by plasma oxidation or ion implantation; exposing said oxidized copper to a gaseous environment comprising a copper complexing ligand selected from the group consisting of a β-diketone, a β-ketoimine and a breakdown product thereof, so as to form a copper-ligand complex; and subliming said copper-ligand complex from said substrate to etch said copper from said substrate.

### BRIEF DESCRIPTION OF SEVERAL VIEWS OF THE DRAWINGS

The invention will be described in conjunction with the following drawings in which like reference numerals designate like elements and wherein:
Figs. 1A, 1B and 1C show a sequence of steps in an integrated etching process according to the invention;
Fig. 2 is a graph of range versus ion energy for energetic ions interacting with solids;
Fig. 3 depicts the variation in profiles as a function of implant energy while keeping the peak concentration at a constant value (8.5 x 10²² atoms/cm³);
Fig. 4 depicts the distribution of oxygen in a 5000 Å copper film after a 300 keV implantation through a 0.25 µm opening;
Fig. 5 depicts the distribution of oxygen in a 5000 Å copper film after a 50 keV implantation through a 0.25 µm opening;
Fig. 6 depicts the oxygen distribution in a 5000 Å copper film after successive implants at 50, 100, and 150 keV; and
Figs. 7A, 7B, 7C and 7D depict alternative embodiments of the masking various modifications that can be made to the mask.

### DETAILED DESCRIPTION OF THE INVENTION

The copper etching method of the invention comprises anisotropically oxidizing at least a portion of a copper film to be etched and contacting the oxidized copper film with an etching agent containing an effective amount of a β-diketone or β-ketoimine ligand. The ligand is reacted with the oxidized copper to form a volatile copper-ligand complex, which is easily removed from the surface of the copper film by sublimation, thereby etching and removing successive layers of the copper film.

The process according to the present invention can be conducted in a continuous process, wherein the copper to be etched is oxidized *in situ*, followed by the immediate formation of the volatile copper-ligand complex, or in a step-wise process. The step-wise process contemplates oxidizing the copper to be etched, and after an indefinite period of time, contacting the oxidized copper with the desired ligand to sublimate the oxidized copper and etch it from the copper film.

Preferably, the method of the invention is effective for removing oxidized copper from a substrate and ineffective for removing neutral copper (i.e., Cu⁰) from a substrate. Oxidized copper reacting with the free ligand forms a stable metal chelate which sublimes from the surface of the substrate, leaving behind unoxidized copper metal. Thus, the differential reactivities of oxidized and neutral copper are exploited to selectively etch anisotropically oxidized copper without substantially disturbing (e.g., undercutting) copper metal which remains unoxidized under an oxidation resistant mask. The chemical equation for this gas phase chelation reaction employing H⁺hfac (where hfac is hexafluoroacetylacetonate or 1,1,1,5,5,5-hexafluoro-2,4-pentanedionate) as the ligand is as follows:

Cu⁺²O + 2 H⁺hfac ⇒ Cu(hfac)₂ + H₂O.

The inventors have demonstrated significant etch rates of Cu⁺²O by H⁺hfac at temperatures above 140°C (about 3000 Å/min at 200°C), partial pressure of H⁺hfac of 0.8 torr and total pressure of 7.6 torr with the balance comprised of N₂. H⁺hfac is reactive with only the oxides of copper, reacting substitutionally with Cu⁺²O and disproportionately with Cu₂O. The inventors have also demonstrated that Cu⁽⁰⁾ is not etched by H⁺hfac at temperatures up to 300°C. The gas phase chelation reaction of the invention is preferably conducted at 20 to 375 °C. If the reaction is conducted at a lower temperature, the reaction rate is too low and if the reaction is conducted at a higher temperature, the reactants break up and lateral spread of etching becomes a problem due to heat-induced oxidation.

Suitable copper complexing ligands according to the invention include β-diketones and β-ketoimines prepared according to methods well known in the art. See, e.g., U.S. Patents Nos. 5,221,366 and 5,782,986. Preferably, the β-diketone or β-ketoimine compound is represented by the formula: 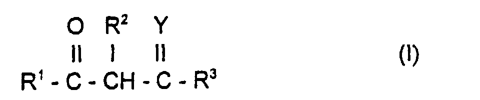 wherein: R¹ and R³ are independently selected from a linear or branched non-fluorinated, partially-fluorinated or fully fluorinated alkyl, alkenyl or aryl group having from 1 to about 8 carbon atoms; R² is a hydrogen atom, a fluorine atom or a linear or branched non-fluorinated, partially-fluorinated or fully fluorinated alkyl or alkenyl group having from 1 to about 8 carbon atoms; and Y is selected from an oxygen atom, N ― R⁴ wherein R⁴ is selected from a non-fluorinated, partially fluorinated, or fully fluorinated alkyl, aryl, aralkyl or hydroxyalkyl group having from 1 to about 10 carbon atoms, or Y is: 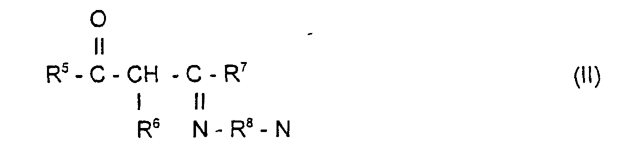 wherein: R⁵, R⁶, and R⁷ are independently selected from a hydrogen atom, a fluorine atom or a linear or branched non-fluorinated, partially fluorinated or fully fluorinated alkyl or alkenyl group having from 1 to about 8 carbon atoms; and R⁸ is a linear or branched non-fluorinated, partially fluorinated or fully fluorinated alkylene, alkenylene, phenylene, alkylphenylene or hydroxalkylene group having from 1 to about 8 carbon atoms.

Formula I represents three distinct types of copper complexing ligands which are each suitable for practicing the etching process of the present invention. Each of the three types is characterized by the definition of the Y group. When Y is an oxygen atom, the ligand forming compound is a β-diketone. When Y is N ― R⁴, the ligand forming compound is a β-ketoimine. Finally, when Y is represented by the structure according to Formula II, the ligand forming compound comprises two β-ketoimines bridged by an organic functionality.

Representative copper complexing ligands suitable for use in the present invention include the following compounds:4-(2,2,2-trifluoroethyl)-imine-1,1,1,5,5,5-hexafluoro-2-pentanone;5-(2,2,2-trifluoroethyl)imino-1,1,1,2,2,6,6,6-octafluoro-3-hexanone;6-(2,2,2-trifluoroethyl)imino-1,1,1, 2,2,3,3,7,7,7-decafluoro-4-heptanone;4-(phenyl)imino-1 1,1,5,5,5-hexafluoro-2-pentanone;4-(2-hydroxyethyl)imino-1,1,1,5,5,5-hexafluoro-2-pentanone;1,2-di(4-imino-1,1,1,5,5,5-hexafluoro-2-pentanone)ethane;1,2-di(5-imino-1,1,1,2,2 ,6,6,6-octafluoro-3-hexanone)ethane;1,2-di(6-imino-1,1,1,2,2,3,3,7,7-decafluoro-4-heptanone)ethane;bis(4-(methylene)imino-1,1,1,5,5,5-hexafluoro-2-pentanone)methane; andbis(4-(methylene)imino-1,1,1,5,5,5-hexafluoro-2-pentanone)methanol.

Preferred copper complexing ligands include fluorinated compounds according to Formula I plus certain breakdown products thereof. Especially preferred copper complexing ligands of the invention include H⁺hfac (available from Air Products and Chemicals, Inc., Allentown, Pa.) and trifluoroacetic acid.

β-diketone and β-ketoimine copper complexing ligands typically only remove metals from surfaces if the metals are in their oxidation states obtained through the formation of oxides or halides of the metals. Consequently, an oxidizing environment is indicated in U.S. Patent No. 5,221,366 as being required for β-diketone and β-ketoimine complexing ligands to react effectively. However, when the metal components to be removed have already been fully oxidized, the ligand forming compound may be utilized in a neutral environment, for instance with only a carrier gas.

A broad range of substrates are suitable for practicing the present invention and include any substrate capable of receiving a copper layer on its surface. The substrate may be any semiconductor substrate material, including silicon or gallium arsenide. The substrate may also be in a micromechanical device or a related functional device. Other suitable substrates include, e.g., printed circuit boards, flat panel displays, surface mount technologies and ball grid arrays. This invention may be used at many different steps in the semiconductor fabrication process and silicon oxide may cover some or all of the substrate surface. Depending on the specific process step, the silicon oxide may be a doped oxide film, a CVD oxide film, or a thermal oxide film. If a doped oxide film, it may be composed of boron or phosphorus doped silica glass, phosphorus doped silica glass, boron doped silica glass, or spin-on-glass. If the silicon oxide is a thermally grown field oxide, it may be formed as a result of a LOCOS process. Also, since this operation may occur at different steps, there may be a composite film structure on the silicon surface. The film structure may include alternating layers of undoped silicon oxide and doped silicon oxide. Additional substrates include, but are not limited to silicon, silicon oxide, borophosphosilicate glass, phosphosilicate glass and strontium titanate. The substrate includes a surface to be etched, preferably comprising a copper film.

Prior to etching and oxidation, the substrate is preferably masked with an oxidation resistant mask to control the etching pattern. The mask comprises an oxidation resistant material, such as, e.g., spin-on-glass, CVD deposited low temperature oxides, photoresist, or SiO₂, SiOₓN_{y}, or SiNₓ deposited by plasma enhanced chemical vapor deposition (PECVD). The most preferred oxidation resistant materials are those which have processing temperatures below 200°C. As copper becomes susceptible to thermally induced oxidation above this temperature, it is best to avoid uncontrolled oxidation of copper.

The mask is preferably applied in a photolithographic method; however, other suitable methods for applying the mask to the substrate are known in the art, and include, e.g., screen printing and direct transfer.

The masked substrate is anisotropically oxidized prior to or simultaneously with the chelation reaction which etches the copper from the substrate. Simultaneously conducting the oxidation and etching processes reduces the amount of oxygen diffusion into the copper layer under the mask, particularly in preferred embodiments of the invention wherein the oxidizing means also breaks down a portion of the copper complexing ligands to form CFₓ passivating materials, which coat and protect non-target surfaces. The ultraviolet irradiation-based oxidation method taught in U.S. Patent No. 5,782,986 does not similarly generate passivating materials and is therefore more susceptible to undesirable undercutting of copper.

Plasma oxidation and ion implantation are the preferred methods for anisotropically oxidizing the copper to be etched. These methods are more precise than the ultraviolet irradiation method of U.S. Patent No. 5,782,986, which suffers from the drawback of collateral oxidation by radiation reflected from the target surface onto other surfaces. Moreover, plasma oxidation allows for control of the ionized oxidation species on the order of electron volts (eV).

In plasma oxidation embodiments, a wafer substrate is subjected to an oxidizing plasma. RF helical resonators, electron cyclotron resonators or DC biased RF plasmas are non-limiting examples of plasma sources. Oxidant from the plasma oxidizes exposed copper. The mask material protects underlying copper from the plasma oxidant and minimizes oxidation of copper in areas under the mask. Process variables, such as substrate bias and temperature, can be optimized to provide uniformity of copper oxidation. Since the plasma process will result in only a thin layer of the copper being oxidized, a sequential plasma process, a pulsed plasma process, or a cyclic plasma process wherein the reactive ambient of the chamber cyclically changes from oxidizing plasma to thermal etching plasma, may be warranted.

It is preferred to run a mixed plasma with oxygen and H⁺hfac (or another fluorinated β-diketone, fluorinated β-ketoimine or a fluorinated breakdown product thereof) in order to generate passivating CFₓ compounds while oxidizing the target surface.

Another method for achieving anisotropic oxidation of the copper metal is ion implantation of an oxidizing atom or molecular ion. In this method, the mask material acts as an implant mask to prevent the implantation of oxidizing molecules during implantation. Sufficient fluence of oxidizing ions is subjected to the volume of the unmasked material to create cupric ions. The oxidation process in the exposed area can be enhanced by creating an amorphous layer in the exposed copper by implantation. This can be done with Cu⁺, or an inert gas ion (e.g., Ne⁺, Ar⁺, Kr⁺, N⁺, N₂⁺, Xe⁺). After implantation, the masked wafer would be subjected to the thermal etching process described above. A co-oxidant may be optionally included in the ambient to facilitate complete conversion of the copper to cupric ion.

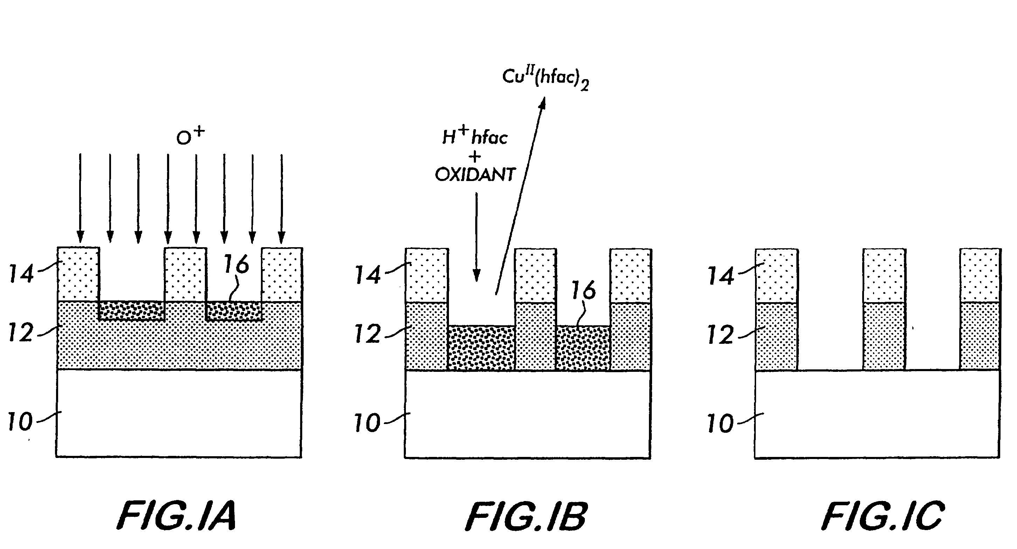

A simple illustration of an integrated etching method of the invention is shown in Figs. 1A, 1B and 1C. Substrate 10 includes a copper film 12 which is selectively masked with oxidation resistant mask 14. Unmasked portions of copper film 12 are anisotropically oxidized to provide oxidized copper to be removed 16, while H⁺hfac is applied to oxidized copper 16 to sublimate it from copper film 12, yielding the anisotropically etched substrate 10 of Fig. 1C.

The invention eliminates several process steps used in a double damascene copper chemical mechanical polishing process. Additionally, the invention is compatible with cluster tools and ion implantation utilized in the manufacture of integrated circuits.

The invention will be illustrated in more detail with reference to the following Examples, but it should be understood that the present invention is not deemed to be limited thereto.

### EXAMPLES

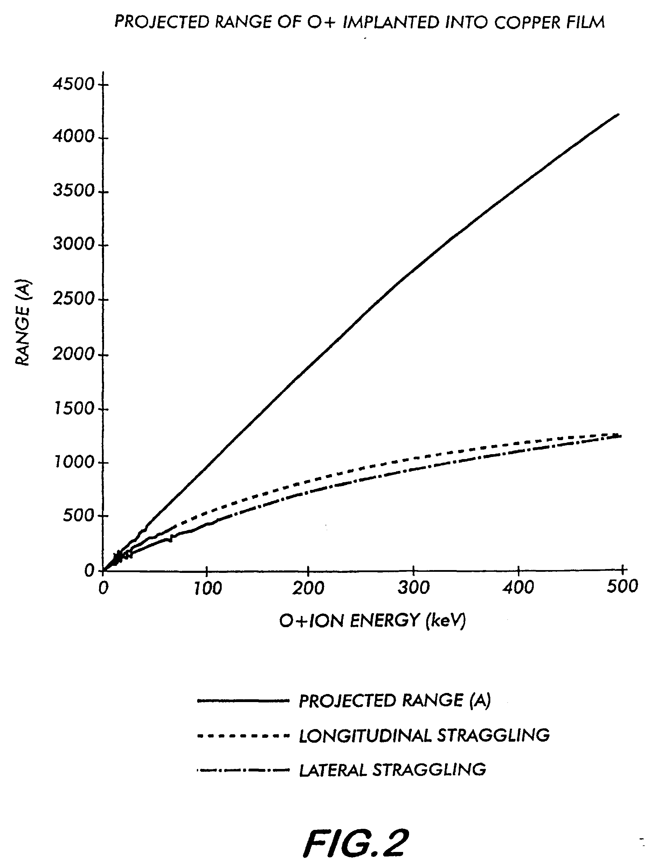

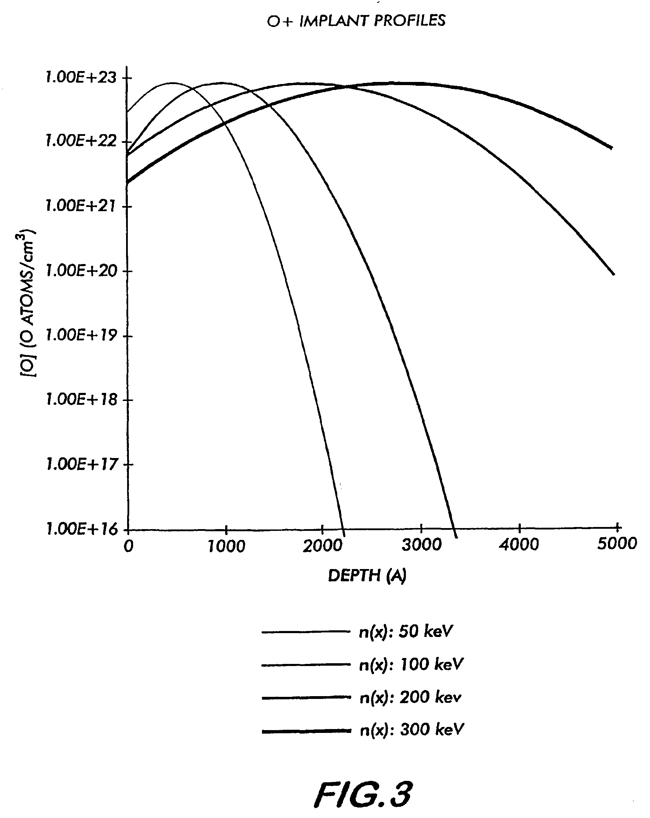

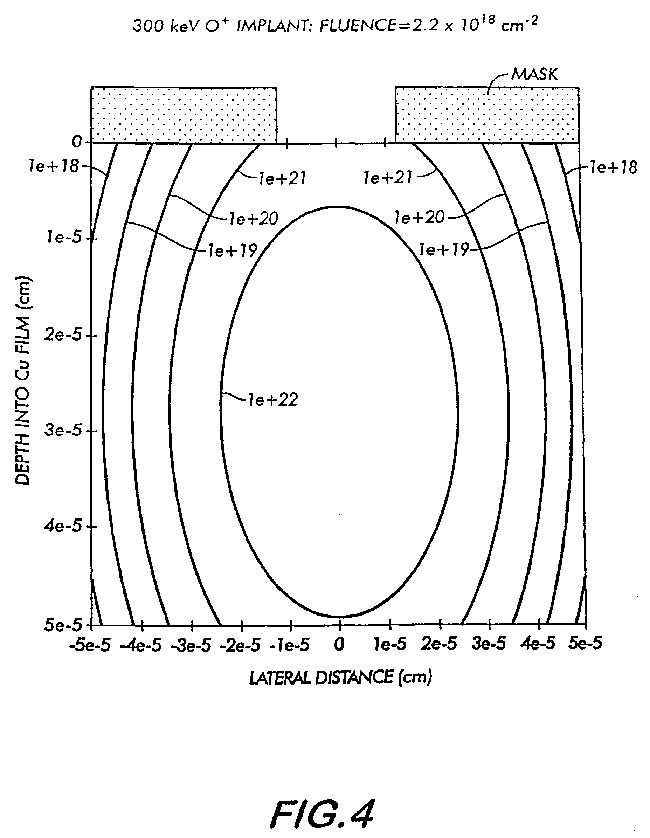

TRIM 95, a software application which generates a Monte Carlo simulation of energetic ions interacting with solids, was used to generate oxygen ion ranges, straggles, and lateral straggles in the following examples. TRIM 95 is a software package produced by J.F. Ziegler at IBM to determine various aspects of the interaction of ions with matter during ion implantation. The software is based on the work by J.P. Biersack et al. on range algorithms (J.P. Biersack et al., Nucl. Instrum. Meth., vol. 174, 257 (1980)) and the work by J.F. Ziegler on stopping theory ("*The Stopping and Range of Ions in Matter,*" vol. 2-6, Pergamon Press (1977-1985)). Figs. 2 and 3 were calculated using TRIM 95, while Figs. 4-6 were generated using the data from the TRIM 95 calculations.

As shown in Fig. 2, there is a considerable amount of lateral straggle, especially for ion energies between 50 and 300 keV, which is a range that is particularly relevant to implanting of oxygen into 5000 Å copper films. The large amount of lateral straggle could result in undercutting of the masked area during the etch if the implant is not properly controlled.

The distribution of implanted oxygen in copper after a variety of implants through a mask opening of 0.25 µm was simulated. Fig. 3 depicts the variation in profiles as a function of implant energy while keeping the peak concentration at a constant value (8.5 x 10²² atoms/cm³). The simulation assumes that the masking material is thick enough to prevent oxygen from being implanted below the mask. As the implant energy increases, the full width half maximum value of the profile also increases, as expected in light of Fig. 2. At first glance, this might appear to suggest using a 300 keV implant to make the entire region under the implant window into CuO since this implant results in high oxygen values throughout the film under the window. However, there are two problems with this approach: (1) the tail of the oxygen distribution continues into the material under the copper film; and (2) the lateral straggle may make the use of implantation impractical for smaller line widths.

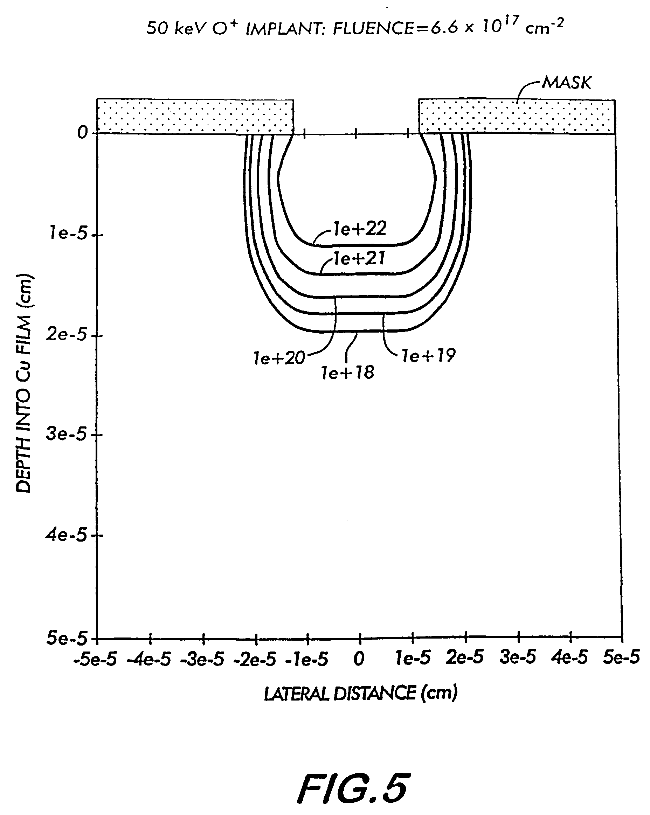

The distribution of oxygen in a 5000 Å copper film after a 300 keV implantation through a 0.25 µm opening is shown in Fig. 4. For comparison, a 50 keV implant through the same opening is shown in Fig. 5. The lower energy implant produces less lateral straggle of the oxygen. Thus, by going to lower energies, the problem of lateral straggle, which would result in undercutting of the copper film during the etch process, is minimized. This suggests using a plasma to oxidize the copper to produce the anisotropic etch since a plasma will typically have ions with energies below 500 eV.

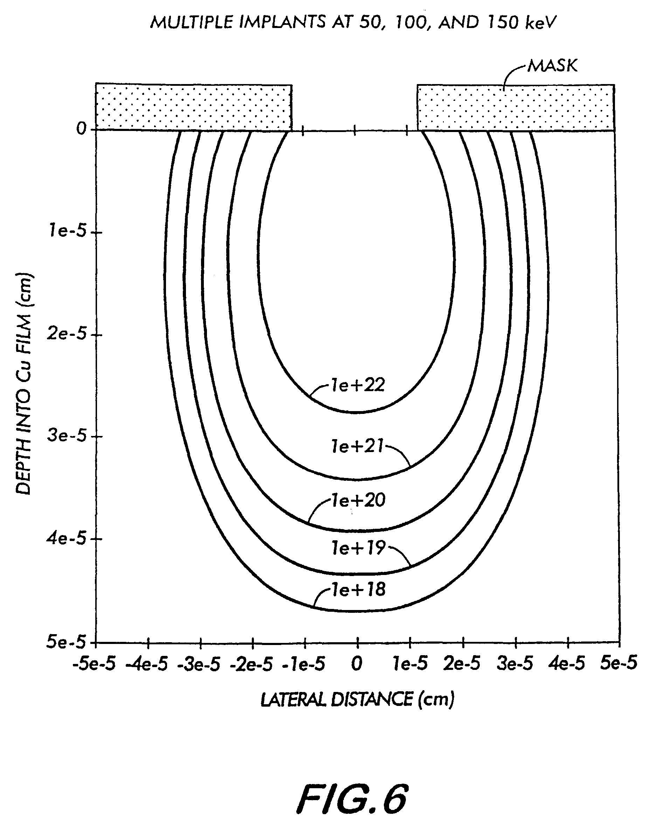

Another method that may be attempted to overcome the lateral straggle problem is to perform successive implants at lower energies and lower fluences. Fig. 6 depicts the oxygen distribution after successive implants at 50, 100, and 150 keV. The fluences of these implants are below those used for Fig. 3, where the goal was to achieve a constant peak concentration for each individual implant. The successive implant technique has the added advantage of keeping the oxygen concentration near the surface close to that needed to make stoichiometric CuO.

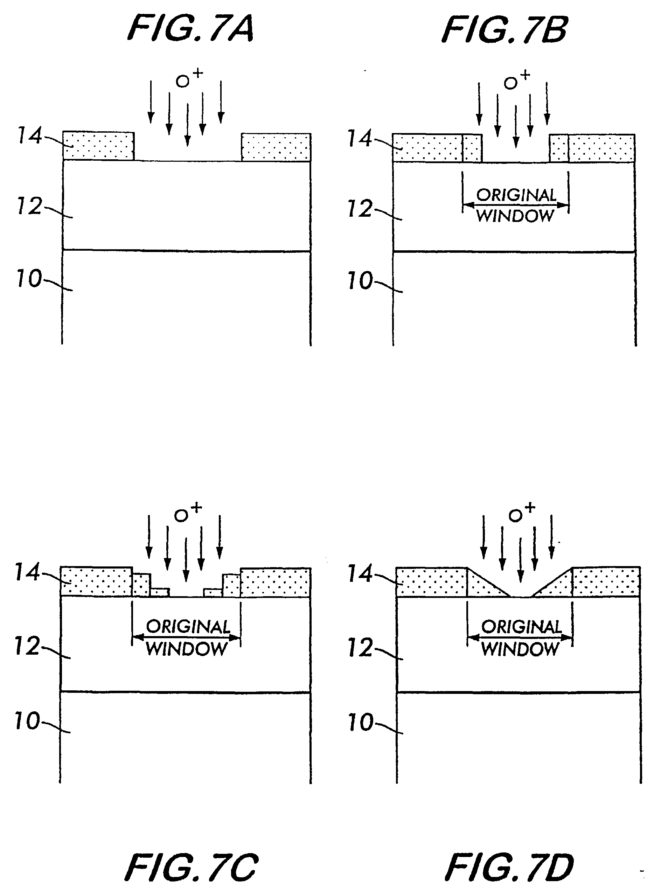

The mask can be modified to influence the final oxygen ion distribution. Figs. 7A-7D illustrate various modifications that can be made to mask 14. Fig. 7A shows an original mask 14 covering copper film 12 on substrate 10. Mask 14 can be modified to reduce the amount of oxygen that gets into masked portions of copper film 12, e.g., by: (1) decreasing the width of the implant window, as shown in Fig. 7B; (2) using multiple masking steps to give various thicknesses of the mask within the implant window where the stepped mask region is thin enough to permit some oxygen to be implanted through these thinner layers, as shown in Fig. 7C; or (3) producing a graded mask within the implant window, as shown in Fig. 7D. All of these modifications will result in changing the final oxygen ion distribution, in particular the lateral distribution.

Another way to use implantation is to damage (e.g., pre-amorphize) the copper to be etched in the implant window. This can be accomplished with inert ions (e.g., Ne⁺, Ar⁺, Kr⁺, N⁺, N₂⁺, Xe⁺) or by implanting Cu⁺. The ion damaged copper can be etched in the presence of a copper complexing ligand alone or along with an oxidizing agent. The etch rate of the ion damaged region should be significantly greater than the copper region that was not exposed to the implanted ion.

While the invention has been described in detail and with reference to specific examples thereof, it will be apparent to one skilled in the art that various changes and modifications can be made therein without departing from the spirit and scope thereof.

## Claims

1. A method for etching copper from a substrate, said method comprising:
anisotropically oxidizing said copper by plasma oxidation or ion implantation;
exposing said oxidized copper to a gaseous environment comprising a copper complexing ligand selected from the group consisting of a β-diketone, a β-ketoimine and a breakdown product thereof, so as to form a copper-ligand complex; and
subliming said copper-ligand complex from said substrate to etch said copper from said substrate.

2. The method of claim 1, wherein said copper is located in a copper film on a surface of said substrate.

3. The method of claim 1, wherein said copper complexing ligand is substantially more effective in removing oxidized copper from said substrate than removing neutral copper from said substrate.

4. The method of claim 1, wherein said copper complexing ligand is represented by the structural formula: 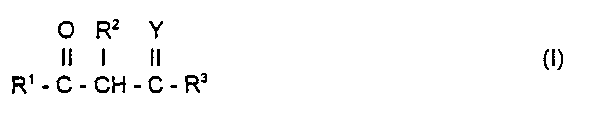 wherein: R¹ and R³ are independently selected from a linear or branched non-fluorinated, partially-fluorinated or fully fluorinated alkyl, alkenyl or aryl group having from 1 to about 8 carbon atoms; R² is a hydrogen atom, a fluorine atom or a linear or branched non-fluorinated, partially-fluorinated or fully fluorinated alkyl or alkenyl group having from 1 to about 8 carbon atoms; and Y is selected from an oxygen atom, N ― R⁴ wherein R⁴ is selected from a non-fluorinated, partially fluorinated, or fully fluorinated alkyl, aryl, aralkyl or hydroxyalkyl group having from 1 to about 10 carbon atoms, or Y is 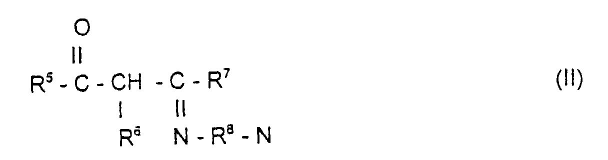 wherein: R⁵, R⁶, and R⁷ are independently selected from a hydrogen atom, a fluorine atom or a linear or branched non-fluorinated, partially fluorinated or fully fluorinated alkyl or alkenyl group having from 1 to about 8 carbon atoms; and R⁸ is a linear or branched non-fluorinated, partially fluorinated or fully fluorinated alkylene, alkenylene, phenylene, alkylphenylene or hydroxalkylene group having from 1 to about 8 carbon atoms.

5. The method of claim 4 ,wherein R¹ and R³ are CF₃, R² is H and Y is O.

6. The method of claim 1, wherein said copper complexing ligand is trifluoroacetic acid.

7. The method of claim 1, wherein said copper complexing ligand is a fluorinated β-diketone, a fluorinated β-ketoimine or a fluorinated breakdown product thereof.

8. The method of claim 7, wherein said oxidizing and said exposing are conducted simultaneously, and said oxidizing causes a portion of said copper complexing agent to breakdown to form passivating CFₓ compounds which coat and protect a copper surface to be retained on said substrate.

9. The method of claim 8 ,further comprising masking selected portions of said substrate with an oxidation resistant mask prior to said oxidizing.

10. The method of claim 9, wherein said oxidizing comprises contacting unmasked portions of said substrate with an oxidizing plasma.

11. The method of claim 9, wherein said oxidizing comprises implanting oxidizing atoms or molecular ions within said substrate.

12. The method of claim 11 ,wherein inert molecular ions are implanted within said substrate to render said substrate susceptible to oxidation.

13. The method of claim 9, wherein said oxidizing comprises bombarding unmasked portions of said substrate with an ion beam.
